# EUROPEAN PATENT APPLICATION

(11) **EP 4 525 043 A1**
(43) Date of publication of application: **19.03.2025**
(21) Application number: 22941538.5
(22) Date of filing: 22.12.2022
(51) Int. Cl.: H01L 25/075, H01L 33/50, G09F 9/33

(54) **LED LIGHT-EMITTING MODULE**

(30) Priority: 13.05.2022 CN 202221156759 U; 13.05.2022 CN 202210526668
(71) Applicant: Godox Photo Equipment Co., Ltd., Shenzhen, Guangdong 518000 (CN)
(72) Inventor: ZENG, Weijun, Shenzhen, Guangdong 518000 (CN)
(74) Representative: Studio Torta S.p.A.
(86) International application number: PCT/CN2022/141167
(87) International publication number: WO 2023/216605

(57) **Abstract**

Disclosed in the present application is an LED light-emitting module, comprising: a light-emitting area, the light-emitting area comprising a plurality of sub-light-emitting areas, and a set of symmetrical light-emitting areas being formed by a first sub-light-emitting area and a second sub-light-emitting area which are symmetrically arranged relative to a symmetric axis, or, the light-emitting area comprising a first light-emitting area and a second light-emitting area, and the first light-emitting area and the second light-emitting area being symmetrically arranged relative to a symmetric axis; and an LED array, arranged in the light-emitting area. Therefore, by means of the symmetrical arrangement of the light-emitting area, light mixing and light complementation of light emitted by the LED array in the light-emitting area are facilitated.

## Description

### CROSS-REFERENCE TO RELATED APPLICATIONS

This application claims a priority to a Chinese patent application No. 2022105266684, titled "LED module" filed on May 13, 2022, which is incorporated herein by reference in its entirety. This application claims a priority to a Chinese patent application No. 2022211567595, titled "LED module" filed on May 13, 2022, which is incorporated herein by reference in its entirety.

### TECHNICAL FIELD

The present application belongs to the field of LED technology, and particularly relates to an LED module.

### BACKGROUND

The light emitting diode (LED) chip is fixed directly on the substrate, and then bonded with the circuit board using Chips on Board (COB) packaging technology through the bonding lead or other ways, and then to form the high light efficiency of the integrated surface light source. This kind of LED light source relative to other structure of the LED light source, has the electrical stability, high color rendering, light uniformity, fast heat dissipation, easy to match the light, free of reflow soldering, reduce the difficulty of the design of the lamps and lanterns, etc., thus it is more and more widely used in the field of LED technology.

At present, there are usually more than one the light emitting region of the LED module, and more than one light emitting region are spaced apart and are located in various positions on the substrate. In order to the convenience and the tightness of the arrangement, more than one light emitting region is not symmetrically provided, which is not convenient for mixture and complement, etc. of the light emitted from the LED array in the light emitting region.

### SUMMARY

Embodiments of the present application provide an LED module that facilitates the mixture and complement of the light emitted from an LED array in the light emitting region through the light emitting region provided symmetrically.

The LED module includes: a substrate including a light emitting region, the light emitting region includes a plurality of light emitting sub-regions, and a first light emitting sub-region and a second light emitting sub-region are provided symmetrically about a symmetry axis to form a group of symmetric light emitting regions; or, the light emitting region includes a first light emitting region and a second light emitting region, and the first light emitting region and the second light emitting region are provided symmetrically about a symmetry axis; an LED array, provided within the light emitting region.

Beneficial effect: the first light emitting sub-region and the second light emitting sub-region are provided symmetrically about the symmetry axis to form a group of symmetric light emitting regions, or the first light emitting region and the second light emitting region are symmetrically provided about the symmetry axis, when the LED array is provided in the light emitting region, it is convenient for mixture and complementary of the light emitted from the first light emitting sub-region and the second light emitting sub-region, or it is convenient for mixture and complementary of the light emitted from the first light emitting region and the second light emitting region.

### BRIEF DESCRIPTION OF THE DRAWINGS

The accompanying drawings herein are incorporated into and form a part of the specification, illustrate embodiments consistent with the present application, and are used in conjunction with the specification to explain the principles of the present application. Obviously, the accompanying drawings in the following description are only some of the embodiments of the present application, and other accompanying drawings may be obtained from these drawings without creative labor for those skilled in the art.
FIG. 1 is a view of a setting of a light emitting region of a first embodiment of an LED module provided in the present application.
FIG. 2 is a view of the setting of symmetric light emitting regions in the light emitting region of the LED module of FIG. 1.
FIG. 3 is a view of the setting of an LED array in the light emitting region of the LED module of FIG. 1.
FIG. 4 is a view of the setting of a first LED sub-array and a second LED sub-array in the symmetric light emitting regions of the LED module of FIG. 2.
FIG. 5 is an enlarged schematic view of the first LED sub-array and the second LED sub-array in FIG. 4.
FIG. 6 is an enlarged schematic view of the first LED sub-array in FIG. 5.
FIG. 7 is an enlarged schematic view of a portion of the LED array in FIG. 3.
FIG. 8 is a view of another setting of the light emitting region of the first embodiment of the LED display module provided in the present application.
FIG. 9 is a top view of a second embodiment of the LED module provided by the present application.
FIG. 10 is an enlarged schematic view of two adjacent first LED columns in the LED module of FIG. 9.
FIG. 11 is an enlarged schematic view of two adjacent second LED columns in the LED module of FIG. 9.
FIG. 12 is a view of the arrangement of a group of the first LED chip column and the second LED chip column symmetrically provided along a symmetry axis in the LED module of FIG. 9.
FIG. 13 is a view of another setting of the first LED column and the second LED column of the LED module provided in the second embodiment of the present application.
FIG. 14 is a view of an electrode setup of the LED module provided in the second embodiment of the present application.

### Number references:

10, a LED module; 11, a substrate; 12, a light emitting region; 121, a first light emitting region; 2211, a first light emitting sub-region; 122, a second light emitting region; 2221, a second light emitting sub-region; 123, a symmetric light emitting region; 124, a first region; 125, a second region; 126, a third region; 13, a non-light emitting region; 14, a LED array; 141, a first LED sub-array; 1411, a first color temperature array; 1412, a first light color array; 142, a second LED sub-array; 1421, a second color temperature array; 1422, a second light color array;
221, a first LED array; 2211, a first LED column; 22111, a first LED group; 22112, a second LED group; 222, a second LED array; 2221, a second LED column; 22211, a third LED group; 22212, a fourth LED group; 231, a first LED chip; 232, a second LED chip; 241, a first electrode; 242, a second electrode.

### DETAILED DESCRIPTION OF THE EMBODIMENTS

### First Embodiment:

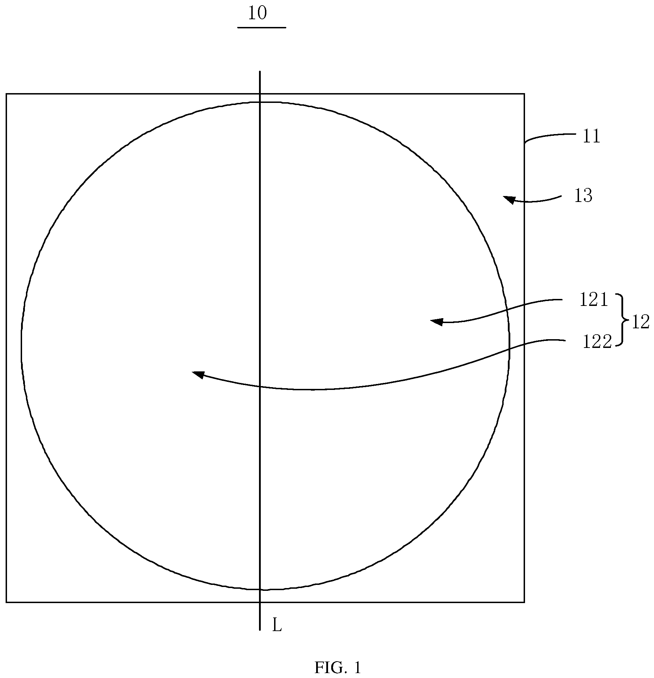

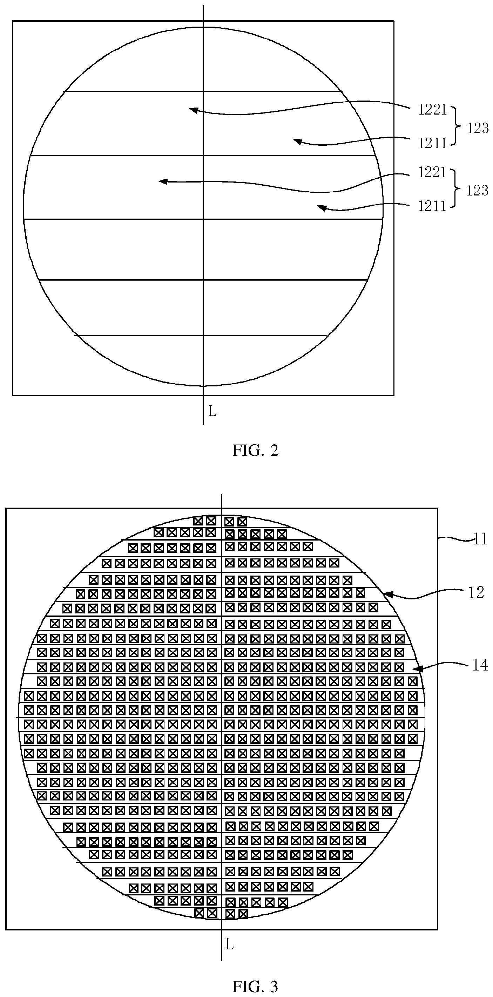

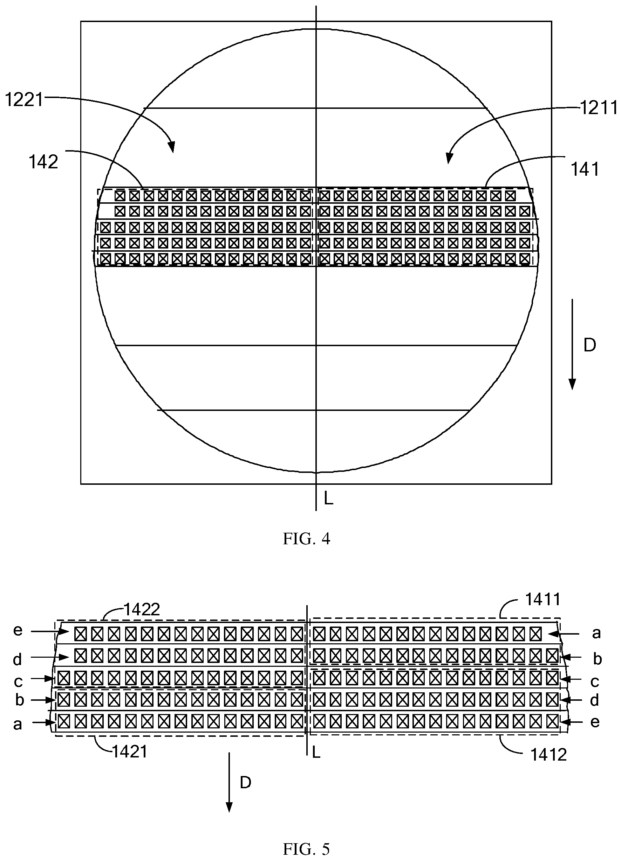

The present application provides an LED module 10, referring to FIGS. 1-FIG. 5. FIG. 1 is a view of the setting of the light emitting region 12 of an embodiment of the LED module 10 provided in the present application. FIG. 2 is a view of the setting of the symmetric light emitting regions 123 in the light emitting region 12 of the LED module 10 of FIG. 1. FIG. 3 is a view of the setting of the LED array 14 in the light emitting region 12 of the LED module 10 of FIG. 1. FIG. 4 is a view of the setting of the first LED sub-array 141 and the second LED sub-array 142 in the symmetric light emitting regions 123 of the LED module 10 of FIG. 2. FIG. 5 is an enlarged view of the first LED sub-array 141 and the second LED sub-array 142 of FIG. 4.

Combined with FIG. 1, the LED module 10 includes a substrate 11, the substrate 11 includes a light emitting region 12. The substrate 11 includes a light emitting surface and a non-light emitting surface opposite to each other, and the light emitting region 12 is provided on the light emitting surface, and then LED chips are mounted in the light emitting region 12 to constitute a light emitting source of the LED module 10.

Specifically, the light emitting surface includes a light emitting region 12 and a non-light emitting region 13, the non-light emitting region 13 is provided around the light emitting region 12, and the non-light emitting region 13 is used for mounting the electrodes, wiring, and other structures of the LED module 10 to supply energy for the LED chips provided in the light emitting region 12.

The light emitting region 12 is divided into a first light emitting region 121 and a second light emitting region 122 symmetrical about the symmetry axis L.

In some specific implementations, the substrate 11 can be a rectangular shape, and the light emitting region 12 is a circular shape and provided in the center of the substrate 11. Of course, the substrate 11 and the light emitting region 12 may also be other shapes, which are not specifically limited herein.

Please refer to FIG. 2, the light emitting region 12 includes a plurality of light emitting sub-regions, the light emitting sub-region in the first light emitting region 121 is defined as a first light emitting sub-region 2211, and the light emitting sub-region in the second light emitting region 122 is defined as a second light emitting sub-region 2221. The first light emitting region 121 includes a plurality of first light emitting sub-regions 2211, and the second light emitting region 122 includes a plurality of second light emitting sub-regions 2221. The first light emitting sub-region 2211 and the second light emitting sub-region 2221 are symmetrically provided about the symmetry axis L. The first light emitting sub-region 2211 and the second light emitting sub-region 2221 symmetrically provided about the symmetry axis L form a ground of symmetric light emitting regions 123.

In conjunction with FIG. 2, a number of symmetric light emitting regions 123 illustrated in FIG. 2 is six, i.e., the first light emitting region 121 includes six first light emitting sub-regions 2211, and the second light emitting sub-region 122 includes six second light emitting sub-regions 2221. Of course, in other embodiments, the number of symmetric light emitting regions 123 is not limited to six.

Please combine FIG. 3 and FIG. 4, the LED module 10 further includes an LED array 14, the LED array 14 is provided in the light emitting region 12, and the LED array 14 includes one LED sub-array in each light emitting sub-region. In conjunction with the foregoing, the LED sub-array in the first light emitting sub-region 2211 is defined as the first LED sub-array 141, and the LED sub-array in the second light emitting sub-region 2221 is defined as the second LED sub-array 142.

It should be understood that FIG. 4 only shows one first LED sub-array 141 and one second LED sub-array 142. In conjunction with FIG. 3, each of the first light emitting regions 2211 is provided with one first LED sub-array 141 and each of the second light emitting regions 2221 is provided with one second LED sub-array 142.

Please refer to FIG. 5, the LED array 14 includes a plurality of LED columns, the first LED sub-array 141 in each first light emitting sub-region 121 includes a plurality of LED columns adjacent to each other. The second LED sub-array 142 in each second light emitting sub-region 122 includes a plurality of LED columns adjacent to each other. The first LED sub-array 141 and the LED columns in the second LED sub-array 142 are provided in the same direction.

Specifically, each LED sub-array includes a light color array for adjusting the light color of the light emitting region 12 and a color temperature array for adjusting the color temperature of the light emitting region 12, and the light color array and the color temperature array are provided row-by-row and spaced apart.

Combined with FIG. 5, the first LED sub-array 141 includes a first color temperature array 1411 and a first light color array 1412, and the second LED sub-array 142 includes a second color temperature array 1421 and a second color temperature array 1422. The first color temperature array 1411 and the first light color array 1412 are provided row-by-row and spaced apart, and the second color temperature array 1421 and the second light color array 1422 are provided in parallel and spaced apart.

More specifically, the light color array includes at least one light color column, and the color temperature array includes a plurality of color temperature columns with different color temperatures.

The light colors of the light color columns can be divided by the wavelength of the light, and the color temperature is a scale indicating the light color of the light source, and the color temperature of the light source is determined by comparing its color to a theoretical thermal blackbody radiator, which can be divided by Kelvin (K). The plurality of color temperature columns with different color temperatures can be in the same light color. For example, the plurality of color temperature columns with different color temperatures may be a plurality of white light color temperature columns with different color temperatures.

The number of light color columns and color temperature columns of the light color arrays of the different LED sub-arrays may be equal. In conjunction with FIG. 5, the number of light color columns of the first light color array 1412 of the first LED sub-array 141 is equal to the number of light color columns of the second light color array 1422 of the second LED sub-array 142, and the number of the light color columns are both three. The number of color temperature columns of the first color temperature array 1411 of the first LED sub-array 141 is equal to the number of color temperature columns of the second color temperature array 1421 of the second sub-array 142, and the number of color temperature columns are both two.

It should be understood that FIG. 5 merely exemplarily shows three light color columns of the first light color array 1412, and exemplarily shows two color temperature columns of the first color temperature array 1411. In other implementations, the first light color array 1412 may include one light color column, two light color columns, more than three light color columns, and the first color temperature array 1411 may include three color temperature columns, four color temperature columns, etc.

Further, the light color arrays and the color temperature arrays of the first LED sub-array 141 and the second LED sub-array 142 are provided in different orders.

Combined with FIG. 4 and FIG. 5, the first color temperature array 1411 and the first light color array 1412 of the first LED sub-array 141 are provided sequentially along the direction D, and the second light color array 1422 and the second color temperature array 1421 of the second LED sub-array 142 are provided sequentially along the direction D. At this time, the light color arrays and the color temperature arrays of the first LED sub-array 141 and the second LED sub-array 142 are provided in different orders.

Further, the first color temperature arrays 1411 and the first light color arrays 1412 in all of the first LED sub-arrays 141 are provided in the same order as shown in FIG. 5. The first color temperature array 1411 and the first light color array 1412 are provided sequentially along the direction D. The first color temperature array 1421 and the first light color array 1422 in all the second LED sub-arrays are provided in the same order as shown in FIG. 5. The second light color array 1422 and the second color temperature array 1421 are sequentially provided along the direction D.

Thus, the light color arrays and the color temperature arrays of the first LED sub-array 141 and the second LED sub-array 142 symmetrical about the symmetry axis L are arranged in different orders, so that light complement is carried out between the first color temperature array 1411 of the first LED sub-array 141 and the second light color array 1422 of the second LED sub-array 142, and light complement is carried out between the first light color array 1412 and the second color temperature array 1421, which in turn can improve the light mixing effect of the LED display module 10.

Specifically, the light color column includes a plurality of light color chips of the same light color close to each other, and the color temperature column includes a plurality of color temperature chips of the same color temperature close to each other.

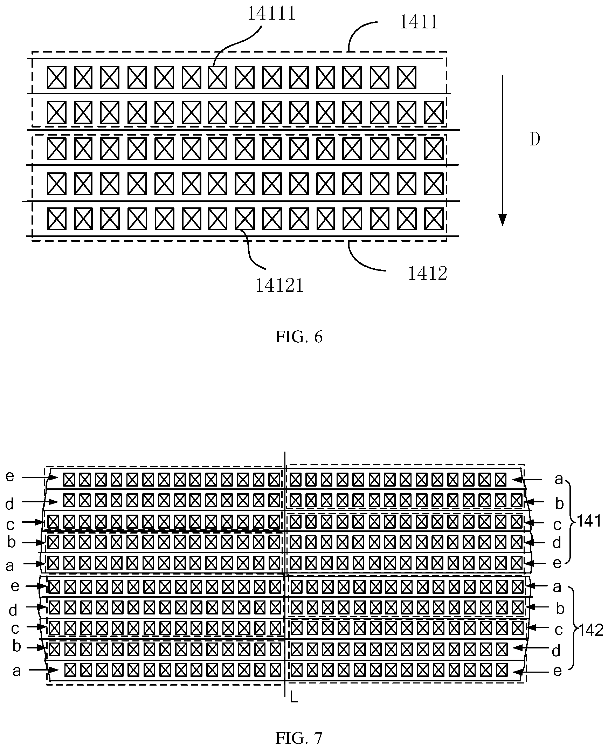

In conjunction with FIG. 6, FIG. 6 is an enlarged schematic view of the first LED sub-array 141 of FIG. 5. Each light color column in the first light color array 1412 includes a plurality of light color chips 14121 close to each other, and the light color chips 14121 in the same light color column emit light of the same light color. Each color temperature column in the first color temperature array 1411 includes a plurality of color temperature chips 14111 close to each other, and the color temperature chips 14111 in the same color temperature column emit light of the same color temperature.

Since the light color chips in the same light color column are provided as light color chips of the same light color, the same kind of chips can be used in the same light color column. Since the color temperature chips in the same color temperature column are provided as chips of the same color temperature, the same kind of chips can be used in the same color temperature column. When the same kind of chips are arranged in the light color column and the color temperature column, respectively, the gap between the same kind of chips can be smaller, such that the same kind of chips are arranged closely. When the chips in the light color column and the color temperature column are arranged closely, more chips can be arranged in the light color column and the color temperature column, thereby increasing the light power of the LED module 10.

In some specific implementations, the light color array includes a plurality of light color columns with different light colors, the light color columns of the first LED sub-array 141 and the light color columns of the second LED sub-array 142 are arranged in different orders in the same direction, and/or the color temperature columns of the first LED sub-array 141 and the color temperature columns of the second LED sub-array 142 are arranged in different orders in the same direction.

In conjunction with FIG. 5, the first light color array 1412 of the first LED sub-array 141 and the second light color array 1422 of the second LED sub-array 142 have the same light color columns, e.g., have the same light color columns c, d, e. The first color temperature array 1411 and the second color temperature array 1412 have the same color temperature columns, e.g., have the same color temperature columns a, b.

Specifically, the color temperature columns of the first LED sub-array 141 and the second LED sub-array 142 are arranged in different orders along the direction D, and the light color columns of the first LED sub-array 141 and the second LED sub-array 142 are arranged in different orders along the direction D. The light color columns of the first LED sub-array 141 and the second LED sub-array 142 may be arranged in partial different orders or completely different orders along the direction D. Accordingly, the same is true for the color temperature column. Of course, when there are two light color columns or two color temperature columns, the light color columns or the color temperature columns are arranged in different orders, i.e., in opposite orders.

More specifically, the light color columns of the first LED sub-array 141 is arranged in the same order as the light color columns of the second LED sub-array 142 in the opposite directions, and/or the color temperature columns of the first LED sub-array 141 is arranged in the same as the color temperature columns of the second LED sub-array 142 in the opposite directions. The arrangement order is the same in the opposite direction, which also means the arrangement order is opposite in the same direction.

In conjunction with FIG. 5, the light color columns c, d, and e of the first LED sub-array 141 are arranged sequentially in the first direction d1, and the light color columns e, d, and c of the second LED sub-array 142 are arranged sequentially in the direction D. Therefore, the light color columns of the first LED sub-array 141 and the light color columns of the second LED sub-array 142 are arranged in opposite orders in the direction D. The color temperature columns a, b of the first LED sub-array 141 are sequentially arranged in the direction D, and the color temperature columns b, a of the second LED sub-array 142 are sequentially arranged in the direction D. Therefore, the color temperature columns of the first LED sub-array 141 and the color temperature columns of the second LED sub-array 142 are arranged in the opposite orders in the direction D.

In combination with the foregoing, the light emitting region 12 includes a plurality of groups of symmetric light emitting regions 123, the light color columns and the color temperature columns of the different first LED sub-arrays 141 in the plurality of groups of symmetric light emitting regions 123 are arranged in the same order in the same direction, and the light color columns and the color temperature columns of the different second LED sub-arrays in the plurality of groups of symmetric light emitting regions 123 are arranged in the same order in the same direction.

Please refer to FIG. 7, FIG.7 is an enlarged schematic view of a portion of the structure of the LED array 14 of FIG. 3. The light color columns and the color temperature columns in the first LED sub-array 141 are arranged in the direction D in the orders a, b, c, d, and e, i.e., in the same order in the same direction. Similarly, the light color columns and the color temperature columns of the different second LED sub-arrays 142 are arranged in the same order in the same direction, without further elaboration.

In conjunction with FIG. 5, in some specific implementations, the light color array includes three light color columns and the color temperature array includes two color temperature columns. As shown in FIG. 5, the first light color array 1412 in the first LED sub-array 141 includes three light color columns and the first color temperature array 1411 in the first LED sub-array 141 includes two color temperature columns.

In some more specific implementations, three light color columns in the light color array are red, green, and blue light color to adjust the light color of the light emitting region 12 by red light color, green light color, and blue light color. The two color temperature columns in the color temperature array are the first color temperature column and the second color temperature column. The first color temperature column may be a low color temperature column and the second color temperature column may be a high color temperature column, to adjust the color temperature of the light emitting region 12 through the first color temperature column and the second color temperature column.

In combination with foregoing, the light emitting region 12 includes a plurality of groups of symmetric light emitting regions 123, the light color columns and the color temperature columns of the at least one group of symmetric light emitting regions 123 are arranged in a first direction d1, and the light color columns and the color temperature columns of the at least one group of symmetric light emitting regions 123 are arranged in a second direction d2, and the first direction d1 is perpendicular to the second direction d2.

It should be understood that in the above embodiment, the light color columns and the color temperature columns in the plurality of groups of symmetric light emitting regions 123 are arranged in the same direction. In this embodiment, the light color columns and the color temperature columns of at least two groups of the symmetric light emitting regions 123 are arranged in mutually perpendicular directions to achieve complementary effects of light in different symmetric light emitting regions 123 for better light mixing effects.

Of course, in other embodiments, the light color columns and the color temperature columns of at least two groups of symmetric light emitting regions 123 are arranged in different directions, but the arrangement directions are not perpendicular, and are not specifically limited herein.

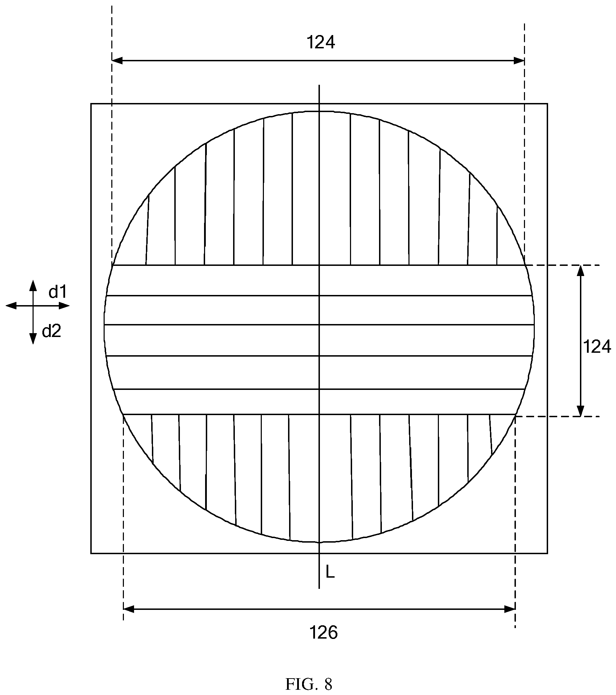

Referring to FIG. 8, FIG. 8 is a view of another setting of the light emitting region 12 of the first embodiment of the LED display module 10 provided in the present application.

In this embodiment, the light emitting region 12 includes a first region 124, a second region 125, and a third region 126. The second region 125 and the third region 126 are located on both sides of the first region 124, and a plurality of groups of symmetric light emitting regions 123 are provided in the first region 124, the second region 125, and the third region 126, respectively. The light color columns and color temperature columns of the symmetric light emitting regions 123 in the first region 124 are arranged along a first direction d1. The light color columns and color temperature columns of the symmetric light emitting regions 123 in the second region 125 and the third region 126 are arranged in a second direction d2.

As shown, the first region 124 is provided in the middle of the light emitting region 12, and the second region 125 and the third region 126 are provided in the upper and lower portions of the first region 124, respectively. It should be understood that the columns in the first region 124 in FIG. 8 indicate light color columns and color temperature columns, five columns in total, and at this time, the first region 124 only shows a symmetric light emitting regions 123. Similarly, the second region 125 and the third region 126 also only show a symmetric light emitting regions 123.

Of course, as described above, the first region 124, the second region 125, and the third region 126 may all include a plurality of symmetric light emitting regions 123, and the plurality of symmetric light emitting regions 123 are symmetrically provided about the symmetry axis L. Moreover, the light emitting region 12 including the first region 124, the second region 125 and the third region 126 is a circular shape.

It should be understood that since the light emitting region 12 is divided into three regions, the light color columns and the color temperature columns in at least two regions are arranged in different directions, which can make regions in the light emitting region 12 whose the light color columns and the color temperature columns are arranged in different directions have a better light complementary effect, thereby improving the light mixing effect of the LED module 10.

In combination with foregoing, the LED module 10 also includes electrodes, the light color chips of one light color column are connected to the electrodes through the same circuit, and the color temperature chips of one color temperature column are connected to the electrodes through the same circuit, to supply energy for the light color columns and the color temperature columns through the electrodes and to control the on-off thereof.

### Second Embodiment

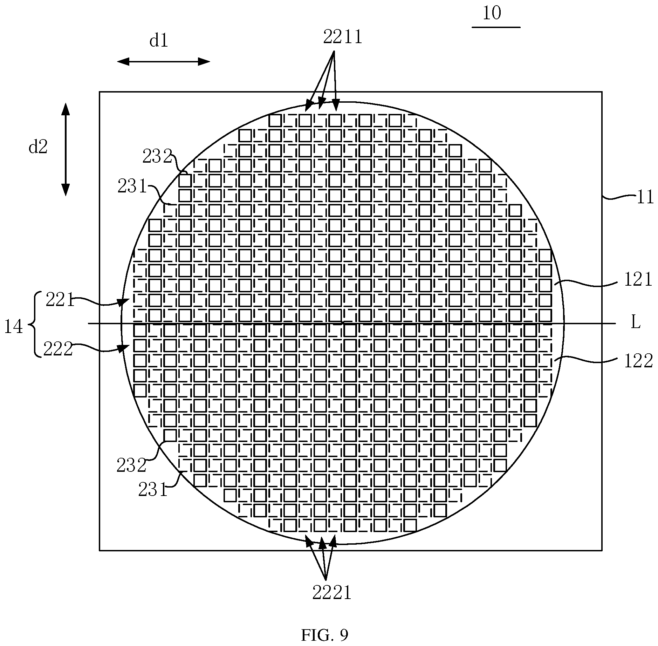

Referring to FIG. 9, FIG. 9 is a top view of a second embodiment of the LED module 10 provided in the present application.

As shown in FIG. 9, the substrate 11 includes a first light emitting region 121 and a second light emitting region 122, and the first light emitting region 121 and the second light emitting region 122 are symmetrically provided about the symmetry axis L.

The substrate 11 has a front side and a back side opposite to the front side, and the front side is a light emitting side to provide an LED chip, which in turn provides a light source for the LED module 10. The front side of the substrate 11 is divided into a light emitting region and a non-light emitting region, the light emitting region is used for setting the LED chip, and the non-light emitting region is used for setting other structures of the LED module 10, such as wires and electrodes.

Specifically, the first light emitting region 121 and the second light emitting region 122 are provided in the light emitting region of the substrate 11, and the first light emitting region 121 and the second light emitting region 122 have equal shapes and sizes, so that the first light emitting region 121 and the second light emitting region 122 can be provided symmetrically. The first light emitting region 121 and the second light emitting region 122 are provided symmetrically about the symmetry axis L. The first light emitting region 121 and the second light emitting region 122 are provided close to each other, and at this time, the edges of the first light emitting region 121 and the edges of the second light emitting region 122 coincide.

The LED module 10 further includes an LED array 14, the LED array 14 is a combination of a plurality of LED chips, and the LED array 14 has at least two rows and two columns. The LED array includes a first LED array 221 provided in the first light emitting region 121 of the substrate 11, and a second LED array 222 provided in the second light emitting region 122 of the substrate 11. It should be understood that that all of the LED chips provided in the first light emitting region 121 constitute the first LED array 221 and all of the LED chips provided in the second light emitting region 122 constitute the second LED array 222.

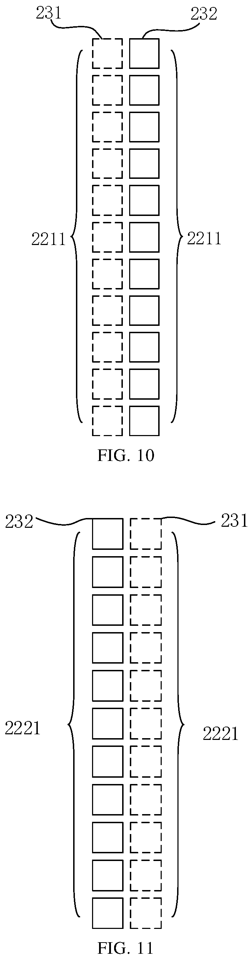

Referring to FIG. 10 and FIG. 11, FIG. 10 is an enlarged schematic view of two adjacent groups of first LED columns 2211 in the LED module 10 of FIG. 9, and FIG. 11 is an enlarged schematic view of two adjacent groups of second LED columns 2221 in the LED module 10 of FIG. 9.

The first LED array 221 has a plurality of first LED columns 2211 provided parallel along the symmetry axis L, and the second LED array 222 has a plurality of second LED columns 2221 provided parallel along the symmetry axis L. The number of the first LED columns 2211 may be the same as the number of the second LED columns 2221, and a row of the first LED columns 2211 may be opposite to a row of the second LED columns 2221.

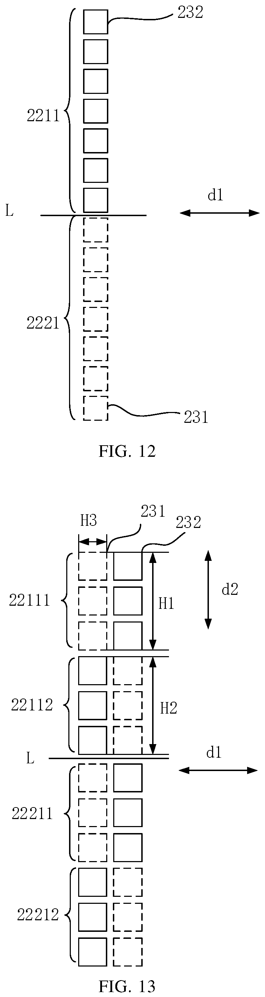

Referring to FIG. 12, FIG. 12 is a view of an arrangement of first LED columns 2211 and second LED columns 2221 symmetrically provided about the symmetry axis L in the LED module 10 of FIG. 9.

Specifically, one first LED column 2211 may be symmetrically provided with one second LED column 2221 along the symmetry axis L, such that one first LED column 2211 is located in the same column as one second LED chip column.

Each first LED column 2211 includes at least a plurality of LED chips, and the number of LED chips in different first LED columns 2211 may be the same or different. Each second LED column 2221 includes at least a plurality of LED chips, and the number of LED chips in different second LED columns 2221 may be the same or different. When the first LED column 2211 and the second LED column 2221 are symmetrically provided, there are a plurality of chips in both the first LED column 2211 and the second LED column 2221, and the number of LED chips in the first LED column 2211 is the same as the number of LED chips in the second LED column 2221.

In combination with the foregoing, two adjacent first LED columns 2211 have complementary light color temperatures, and two adjacent second LED columns 2221 have complementary light color temperatures. Moreover, the light emitting color temperature of the first LED column 2211 and the light emitting color temperature of the second LED column 2221 provided symmetricall about the symmetry axis L are complementary.

The color temperature is a scale indicating the light color of the light source in Kelvin (K), and the color temperature of the light source is determined by comparing its color with a theoretical thermal blackbody radiator. The light emitting color temperature of the first LED column 2211 is the light emitting color temperature of the LED chips in the first LED column 2211, and the light emitting color temperature of the second LED column 2211 is the light emitting color temperature of the LED chips in the second LED column 2221. Different LED chips in the first LED column 2211 can emit different color temperatures, and at this time, the first LED column 2211 includes a plurality of color temperatures. Correspondingly, the second LED column 2221 is the same.

Specifically, the light emitting color temperature of one of the two adjacent first LED columns 2211 is the first color temperature, the light emitting color temperature of the other of the two adjacent first LED columns 2211 is the second color temperature, and the light emitting color temperatures of two adjacent first LED columns 2211 are complementary to each other, i.e., the first color temperature and the second color temperature are complementary to each other. In combination with the above, the first color temperature may include only one color temperature, at this time, the second color temperature correspondingly includes a second color temperature, and the first color temperature may include a plurality of color temperatures, at this time, the second color temperature correspondingly includes a plurality of color temperatures.

The complement of color temperatures may be complement between different color temperatures, specifically between a high color temperature and a low color temperature. In combination with the above, for example, when the first color temperature and the second color temperature both include a color temperature, the first color temperature may be a low color temperature, and the second color temperature may be a high color temperature, and at this time, the first color temperature and the second color temperature are complementary. When the first color temperature and the second color temperature both include a plurality of color temperatures, the plurality of color temperatures in the first color temperature are complementary to the plurality of color temperatures in the second color temperature, respectively, and thus the complement between the first color temperature and the second color temperature is achieved.

In summary, when the LED module 10 provided in the present application performs color temperature complement, two adjacent first LED columns 2211 are complementary and symmetrical first LED columns 2211 and second LED columns 2221 are complementary, such that the complement of color temperatures between two columns is achieved. The complementary color temperature of adjacent single LED chips in the prior art generally arranges different LED chips adjacent to each other, which in turn causes adjacent LED chips to emit light of different color temperatures to achieve complement. In the present application, when the light colors of columns are complementary, the same LED chips can be arranged adjacent to each other, and the same LED chips arranged adjacent to each other form a color temperature, and then constitute the color temperature of one LED chip column, and then the color temperature of columns are complementary.

It should be understood that when the same LED chips are arranged adjacent to each other, compared to the way in which different LED chips are arranged adjacent to each other, the LED chips can be arranged more compact, and then more LED chips are arranged in the same region, thereby improving the light power density of the LED module 10.

In summary, compared to the LED modules in the prior art, the LED chips of the LED module 10 provided in the present application are arranged more closely, and have a higher light emitting power density.

Combined with FIG. 9, FIG. 10, and FIG. 11, in some specific embodiments, the plurality of first LED columns 2211 are arranged closely to each other, and the plurality of second LED columns 2221 are arranged closely to each other.

In conjunction with FIG. 10, the plurality of first LED columns 2211 are arranged closely to each other, i.e., two adjacent first LED columns 2211 are arranged closely to each other, and the plurality of second LED columns 2221 are arranged closely to each other, i.e., two adjacent second LED columns 2221 are arranged closely to each other. The first LED columns 2211 are arranged closely to each other, which can means that there is no retractable space between the first LED columns 2211, and the same is true for the close arrangement of the second LED columns 2221. Specifically, adjacent first LED columns 2211 are arranged closely, which may be that LED chips opposite to each other in adjacent first LED columns 2211 are arranged closely. For example, when the adjacent first LED columns 2211 are arranged closely to each other, two LED chips located in adjacent columns and provided opposite to each other are arranged closely to each other.

It should be understood that a plurality of columns of LED chips are provided closely to each other, the gaps between the columns can be narrowed, and thus more LED chip columns can be arranged in a limited region, thereby increasing the light power density of the LED module 10.

Combined with FIG. 9, the symmetry axis L extends along the first direction d1, the first LED column 2211 and the second LED column 2221 extend along the second direction d2, and the first direction d1 is perpendicular to the second direction d2. By such a setting, the first LED column 2211 and the second LED column 2221 are arranged as a regular array, and the gap between the LED chips can be further reduced by such a regular arrangement to further improve the light power density of the LED module 10.

Combining FIGS. 9 with 10, one of the two first LED columns 2211 provided adjacent to each other in the first direction d1 includes a plurality of first LED chips 231 close to each other along the second direction d2, and the other of the two first LED columns 2211 includes a plurality of second LED chips 232 close to each other along the second direction d2, and the first LED chips 231 and the second LED chips 232 have a complementary light color temperature.

Combining FIGS. 9 with FIG. 11, one of the two second LED columns 2221 provided adjacent to each other in the first direction d1 includes a plurality of first LED chips 231 close to each other along the second direction d2, and the other of the two second LED columns 2221 includes a plurality of second LED chips 232 close to each other along the second direction d2.

Combining FIGS. 9 with 12, in such an embodiment, the first LED chip 231 and the second LED chip 232 are provided in the first LED column 2211 and the second LED column 2221 symmetrical along the symmetry axis L, respectively.

The first LED chips 231 are arranged closely to each other may be, which can mean that there is no retractable space between the first LED chips 231, and the second LED chips 232 are arranged closely to each other.

In such an implementation, all of the first LED chips 231 in the one first LED column 2211 have the same chip type, which may specifically be the same chip, and all of the second LED chips 232 in the second LED column 2221 have the same chip type, which may specifically be the same chip. In combination with the foregoing, at this time, the first color temperature in the first LED column 2211 includes only one color temperature, such as a low color temperature. The second color temperature in the second LED chip 2221 includes only one color temperature, for example, a high color temperature.

Combining the foregoing with FIGS. 1-FIG. 4, the LED chip indicated by the dashed line box is the first LED chip 231, and the second LED chip 232 is indicated by the solid line box. In some specific application scenarios, the first LED chip 231 is an LED chip capable of emitting light with a low color temperature, and the second LED chip 232 is an LED chip capable of emitting light with a high color temperature.

With this implementation, the first LED chips 231 in the first LED column 2211 provided in the second direction d2 are the same and arranged adjacent to each other, and the second LED chips 232 provided in the second direction d2 are the same and arranged adjacent to each other, so that the gap between the LED chips can be saved to a greater extent, and the light power density of the LED module 10 can be improved to a greater extent.

Referring to FIG. 13, FIG. 13 is a view of another arrangement of the first LED column 2211 and the second LED column 2221 of the second embodiment of the LED module 10 provided in the present application.

In some specific embodiments, each first LED column 2211 includes a plurality of first LED groups 22111 and second LED groups 22112 provided in a second direction d2. The first LED group 22111 includes a plurality of first LED chips 231 close to each other, the second LED group 22112 includes a plurality of second LED chips 232 close to each other, and the first LED chips 231 and the second LED chips 232 have complementary light color temperatures.

The first LED chips 231 in the first LED group 22111 in the first LED column 2211 are the same chips, and the second LED chips 232 in the second LED chip group 22112 in the first LED column 2211 are the same chips. Since the chips in the first LED group 22111 are the same and arranged adjacent to each other, the LED chips can be arranged closely, thereby increasing the light power density of the LED module 10.

FIG. 13 only shows the first LED column 2211 including two groups of the first LED groups 22111 and second LED groups 22112 provided along the second direction d2. In other implementations, three or more groups of first LED groups 22111 and second LED groups 22112 may be included, the first LED groups 22111 and second LED groups 22112 are staggered. For example, when the first LED column 2211 includes four groups of the first LED group 22111 and the second LED group 22112 provided along the second direction d2, the specific arrangement may be as follows: the first LED group 22111, the second LED group 22112, the first LED group 22111, and the second LED group 22112 provided sequentially along the second direction d2.

Correspondingly, the second LED column 2221 also includes a plurality of groups of third LED groups 22211 and fourth LED groups 22212, and the third LED group 22211 and the fourth LED group 22212 may be provided with reference to the above-described setting of the first LED group 22111 and the second LED group 22112. In combination with the specific implementation of the light color temperature complement of the above first LED column 2211 and the second LED column 2221, specifically the color temperature complement between the chips of the LED group in the first LED column 2211 and the chips of the LED group in the second LED chip column, specifically the color temperature complement of the symmetrical LED group in the first LED column 2211 and the second LED column 2221.

In combination with the above embodiments and FIG. 13, light color temperature complements of the first LED column 2211 and the second LED column 2221 can be: the complement of the color temperatures of the first LED group 22111 of the first LED column 2211 and the fourth LED group 22212 of the second LED column 2221, and the complement the color temperatures of the second LED group 22112 of the first LED column 2211 and the third LED group 22211 of the second LED column 2221. Specifically, it may be that the LED chips in the third LED group 22211 of the second LED column 2221 and the LED chips in the first LED group 22111 of the first LED column 2211 are both first LED chips 231, and the LED chips in the fourth LED group 22212 of the second LED column 2221 and the first LED group 2211 of the first LED column 2211 are all first LED chips 22112 are both second LED chips 232. As shown in FIG. 5, the same first LED chips 231 are indicated by dashed boxes and the same second LED chips 232 are indicated by solid boxes.

In such an embodiment, the complement of light color temperatures of two adjacent first LED columns 2211 may be the complement of light color temperatures of the LED groups provided opposite to each other in the two adjacent first LED columns 2211. As shown in FIG. 5, the LED chips of the LED group provided opposite to the first LED group 22111 in the first LED column 2211 may be the same as the LED chips in the second LED group 22112 in the first LED column 2211, both of which are second LED chips 232.

Since the first LED column 2211 and the second LED column 2221 are divided into a plurality of LED groups, respectively, a better light mixing effect can be achieved on the basis of realizing the same LED chips arranged adjacent to each other.

Based on the above implementation in which the first LED column 2211 is divided into a plurality of chip groups and each chip group includes a plurality of the same chips, in some other different implementations, some of the LED groups may include one LED chip.

In conjunction with FIG. 13, in some specific implementations, the first LED group 22111 and the second LED group 22112 of the first LED column 2211 have lengths H1, H2 in the second direction d2, respectively, greater than or equal to 2 millimeters in order to provide sufficient LED chips in one LED group. The length sum of the first LED column 2211 and the second LED column 2221 in the second direction d2 is less than or equal to 62 millimeters.

In conjunction with FIG. 9, in some specific implementations, the first light emitting region 121 and the second light emitting region 122 are a generally circular shape. In combination with the above embodiment that the first light emitting region 121 and the second light emitting region 122 are provided symmetrically, the first light emitting region 121 and the second light emitting region 122 are both a semi-circular shape. In combination with the above implementation in which the length sum of the first LED column 2211 and the second LED column 2221 in the second direction d2 is less than or equal to 62 millimeters, i.e., the diameter of the circular light emitting region formed by the first light emitting region 121 and the second light emitting region 122 is less than or equal to 62 millimeters.

In combination with the foregoing, in some specific implementations, a plurality of first LED chips 231 close to each other are connected through the same line circuit, and a plurality of second LED chips 232 close to each other are connected through the same line circuit.

In combination with the foregoing, when each first LED column 2211 includes a plurality of first LED chips 231 close to each other along the second direction d2, and each second LED column 2221 includes a plurality of second LED chips 232 close to each other along the second direction d2, all the first LED chips 231 in the first LED column 2211 in a column are connected through the same line circuit to simultaneously control all the first LED chips 231 in the one first LED column 2211.

In combination with the above, when each the first LED column 2211 includes a plurality of groups of first LED groups 22111 and second LED groups 22112 provided along the second direction d2, the first LED groups 22111 include a plurality of first LED chips 231 close to each other, and the first LED groups 22111 include a plurality of second LED chips 232 close to each other. The first LED group 22111 and the second LED group 22112 are connected through different line circuits respectively, thereby realizing independent control of different LED groups, thereby realizing flexible control of the LED light emitting mode of the LED module 10.

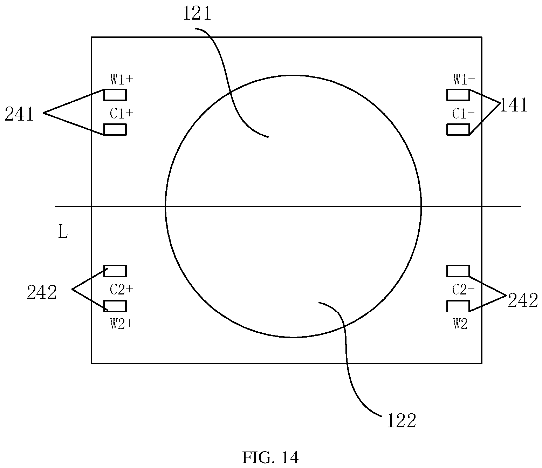

Referring to FIG. 14, FIG. 14 is a view of an electrode setting of the LED module 10 provided in the second embodiment of the present application.

The LED module is provided with at least a first electrode 241 and a second electrode 242, the first electrode 241 and the second electrode 242 are provided in a non-light emitting region of the substrate 11. The first electrode is connected to a plurality of first LED chips close to each other for driving the plurality of first LED chips close to each other, and the second electrode is connected to a plurality of second LED chips close to each other for driving the plurality of second LED chips close to each other.

Specifically, the first electrode 241 includes positive electrodes C1+, W1+, and the first electrode 241 further includes negative electrodes C1-, W1-. The second electrode 242 includes positive electrodes C2+, W2+, and the second electrode 232 further includes negative electrodes C2-, W2-. The first electrode 241 and the second electrode 242 are provided in the corner region of the substrate 11, thereby facilitating the setting of the electrodes and wires.

Specifically, the LED array 14 is chips on board (COB) package array, i.e., a chip-on-board package array. In realizing the LED array package, the LED chips are first provided on the substrate 11, and then the LED chips are packaged as a whole.

It should be understood that by the above encapsulation method, the same chips can be provided closely to each other, and then the chips close to each other can be encapsulated as a whole, so that the spacing between the same chips in the encapsulated LED array 14 is smaller, and the arrangement density of the chip can be increased to improve the power of the LED module 10.

Specifically, the LED module 10 also includes a first fluorescent layer (not shown in the figure) and a second fluorescent layer (not shown in the figure), the first fluorescent layer covers the first LED chip 231 to form a first light emitting region 121, and the second fluorescent layer covers the second LED chip 232 or the second fluorescent layer covers the first LED chip 231 and the second LED chip 232 to form a second light emitting region 122.

In the formation process of the first light emitting region 121 and the second light emitting region 122, the first LED chip 231 is first covered with the first fluorescent layer to form the first light emitting region 121, and then the second fluorescent layer is covered with the first LED chip 231 and the second LED chip 232 to form the second light emitting region 122. The first fluorescent layer is composed of a low color temperature material, and the second fluorescent layer is composed of a high color temperature material.

## Claims

1. A light emitting diode (LED) module, **characterized by** comprising:
a substrate, comprising a light emitting region, wherein the light emitting region comprises a plurality of light emitting sub-regions, and a first light emitting sub-region and a second light emitting sub-region are provided symmetrically about a symmetry axis to form a group of symmetric light emitting regions; or
the light emitting region comprises a first light emitting region and a second light emitting region, and the first light emitting region and the second light emitting region are provided symmetrically about a symmetry axis;
an LED array, provided within the light emitting region.

2. The LED module according to claim 1, wherein
the LED array comprises an LED sub-array in each of the plurality of light emitting sub-regions, wherein each LED sub-array comprises a light color array for adjusting a light color of the light emitting region and a color temperature array for adjusting a color temperature of the light emitting region, and the light color array and the color temperature array are provided row-by-row and at intervals;
wherein the light color array comprises at least one light color column, and the color temperature array comprises a plurality of color temperature columns with different color temperatures;
wherein a first LED sub-array of the first light emitting sub-region and a second LED sub-array of the second light emitting sub-region are symmetrically provided about the symmetry axis, wherein the light color array and the color temperature array of the first LED sub-array and the second LED sub-array are arranged in different orders.

3. The LED module according to claim 2, wherein
the light color array comprises a plurality of light color chips of a same light color close to each other, and the color temperature array comprises a plurality of color temperature chips of a same color temperature close to each other.

4. The LED module according to claim 2, wherein
the light color array comprises a plurality of the light color columns with different light colors, wherein the light color columns of the first LED sub-array are arranged in different orders in a same direction as the light color columns of the second LED sub-array; and/or
the color temperature columns of the first LED sub-array are arranged in different orders in a same direction as the color temperature columns of the second LED sub-array.

5. The LED module according to claim 4, wherein
the light color columns of the first LED sub-array are arranged in a same order as the light color columns of the second LED sub-array in opposite directions; and/or
the color temperature columns of the first LED sub-array are arranged in a same order as the color temperature columns of the second LED sub-array in the opposite directions.

6. The LED module according to claim 4, wherein
the light emitting region comprises a plurality of the symmetric light emitting regions, light color columns and color temperature columns of different first LED sub-arrays are the same in the same direction, and light color columns and color temperature columns of different second LED sub-arrays are the same in the same direction.

7. The LED module according to claim 2, wherein
the light color array comprises three light color columns and the color temperature array comprises two color temperature columns.

8. The LED module according to claim 7, wherein
the three light color columns are red, green, and blue light columns, and the two color temperature columns are a first color temperature column and a second color temperature column.

9. The LED module according to claim 2, wherein
the light emitting region comprises a plurality of the symmetric light emitting regions, at least one group of the light color columns and the color temperature columns of the symmetric light emitting regions are arranged in a first direction, and at least one group of the light color columns and the color temperature columns of the symmetric light emitting regions are arranged in a second direction, wherein the first direction is perpendicular to the second direction.

10. The LED module according to claim 9, wherein
the light emitting region comprises a first region, a second region, and a third region, wherein the second region and the third region are located on two sides of the first region, and a plurality of the symmetric light emitting regions are provided in the first region, the second region, and the third region, wherein the light color columns and the color temperature columns of the symmetric light emitting regions in the first region are aligned in the first direction, and the light color columns and the color temperature columns of the symmetric light emitting regions in the second region and the third region are arranged in the second direction.

11. The LED module according to claim 10, wherein
the symmetric light emitting regions in the first region, the second region, and the third region are symmetrically provided about a same symmetry axis, and the light emitting region is provided in a circular shape.

12. The LED module according to claim 1, wherein
the LED array comprises a first LED array provided in the first light emitting region of the substrate and a second LED array in the second light emitting region, wherein the first LED array has a plurality of first LED columns arranged row-by-row along the symmetry axis, and the second LED array has a plurality of second LED columns arranged row-by-row along the symmetry axis;
wherein light emitting color temperatures of two adjacent first LED columns are complementary, and light emitting color temperatures of two adjacent second LED columns are complementary, wherein the light emitting color temperatures of the first LED columns and the light emitting color temperatures of the second LED columns symmetrically about the symmetric axis are complementary.

13. The LED module according to claim 12, wherein the plurality of the first LED columns are arranged close to each other, and the plurality of the second LED columns are arranged close to each other.

14. The LED module according to claim 12, wherein
the symmetry axis is extended in the first direction, and the first LED columns and the second LED columns are extended in the second direction, wherein the first direction is perpendicular to the second direction.

15. The LED module according to claim 14, wherein
one of the two first LED columns arranged adjacent to each other in the first direction comprises a plurality of first LED chips close to each other in the second direction, and another of the two first LED columns comprises a plurality of second LED chips close to each other in the second direction, and the light emitting color temperatures of the first LED chips and the second LED chips are complementary; and
one of the two second LED columns arranged adjacent to each other in the first direction comprises a plurality of the first LED chips close to each other in the second direction, and another of the two second LED columns comprises a plurality of the second LED chips close to each other in the second direction.

16. The LED module according to claim 14, wherein
each first LED column comprises a plurality of first LED groups and second LED groups provided in the second direction, wherein each first LED group comprises a plurality of the first LED chips close to each other, each second LED group comprises a plurality of the second LED chips close to each other, and the light emitting color temperatures of the first LED chips and the second LED chips are complementary.

17. The LED module according to claim 16, wherein
the first LED group and the second LED group have a length greater than or equal to 2 millimeters in the second direction, respectively.

18. The LED module according to claim 12, wherein
the first light emitting region and the second light emitting region are provided in a generally circular shape.

19. The LED module according to claim 15 or 16, wherein
the first LED chip is connected through a same line circuit and the second LED chip is connected through a same line circuit.

20. The LED module according to claim 12, wherein
the LED array is a chip-on-board package array.

21. The LED module according to claim 15 or 16, wherein
the LED module further comprises a first fluorescent layer and a second fluorescent layer, wherein the first fluorescent layer covers the first LED chip, and the second fluorescent layer covers the second LED chip or the second fluorescent layer covers the first LED chip and the second LED chip.
